Europäisches Patentamt

European Patent Office

Office européen des brevets

(11) Numéro de publication: **0 305 253 B1**

# FASCICULE DE BREVET EUROPEEN

(45) Date de publication de fascicule du brevet: **14.07.93** (51) Int. Cl.⁵: **H01L 29/80**, H01L 29/205, //H01L27/08

(21) Numéro de dépôt: **88402014.0**

(22) Date de dépôt: **03.08.88**

---

(54) **Transistor hyperfréquence à double hétérojonction.**

---

(30) Priorité: **05.08.87 FR 8711144**

(43) Date de publication de la demande:
**01.03.89 Bulletin 89/09**

(45) Mention de la délivrance du brevet:
**14.07.93 Bulletin 93/28**

(84) Etats contractants désignés:
**DE GB IT NL**

(56) Documents cités:
**EP-A- 0 067 721**
**US-A- 4 556 895**

**PATENT ABSTRACTS OF JAPAN, vol. 11, no. 224 (E-525)[2671], 21 juillet 1987, page 25 E 525; & JP-A-62 40 778**

**IEEE TRANSACTIONS ON ELECTRON DEVICES, vol. ED-28, no. 7, juillet 1981, pages 790-795, IEEE, New York, US; D. DELAGE-BEAUDEUF et al.: "Charge control of the heterojunction two-dimensional electron gas for MESFET application"**

(73) Titulaire: **THOMSON-CSF SEMICONDUCTEURS SPECIFIOUES**
**51 Esplanade du Général de Gaulle**
**F-92800 Puteaux(FR)**

(72) Inventeur: **Delagebeaudeuf, Daniel**
**THOMSON-CSF**
**SCPI-19, avenue de Messine**
**F-75008 Paris(FR)**
Inventeur: **Godart, Jean-Jacques THOMSON-CSF**
**SCPI-19, avenue de Messine**
**75008 Paris(FR)**
Inventeur: **Rambier, Françoise THOMSON-CSF**
**SCPI-19, avenue de Messine**
**F-75008 Paris(FR)**
Inventeur: **Gibeau, Pierre THOMSON-CSF**
**SCPI-19, avenue de Messine**
**F-75008 Paris(FR)**

(74) Mandataire: **Taboureau, James et al**
**THOMSON-CSF, SCPI, B.P. 329, 50, rue Jean-Pierre Timbaud**
**F-92402 Courbevoie Cédex (FR)**

---

Rank Xerox (UK) Business Services
(3.10/3.6/3.3.1)

IEEE TRANSACTIONS ON ELECTRON DEVI-CES, vol. ED-29, no. 6, juin 1982, pages 955-960, IEEE, New York, US; D. DELAGE-BEAUDEUF et al.: "Metal-(n) AlGaAs-GaAs two-dimensional electron gas FET"

## Description

La présente invention concerne un transistor à effet de champ, réalisé en matériaux de la famille III-V tels que Ga AS et Al Ga As, comportant une double hétérojonction. Chaque hétérojonction est réalisée dans des conditions telles qu'un gaz bidimensionnel de porteurs de charges puisse y apparaître à l'interface, mais les types de dopages des couches de matériaux semiconducteurs constituant ces hétérojonctions sont choisis (n et p) pour que le transistor possède un canal n et un canal p, qui soient utilisés simultanément ou non.

Les transistors à effet de champ de type TEGFET (Two dimensional Electron Gas Field Effect Transistor) sont maintenant bien connus, et la théorie en a été établie dès 1979. Ces transistors sont essentiellement constitués par une hétérojonction entre un matériau à faible largeur de bande interdite, Ga As par exemple, non intentionnellement dopé (NID) ou faiblement dopé n ou p, et un matériau à grande largeur de bande interdite, Al Ga As par exemple, dopé de type n. Dans certaines conditions - adaptation des paramètres de maille, épaisseur des couches, niveaux de dopage, etc ... - apparait un gaz bidimensionnel d'électrons, très mobile, à l'hétérojonction du côté du matériau à faible largeur de bande.

Ces transistors utilisent généralement un canal n, parce que les électrons sont plus mobiles que les trous, donc plus intéressants pour travailler en hyperfréquences, dans les gigahertz.

On connait cependant, décrit dans Patent Abstracts of Japan, vol 11, n° 224, page 25 E 525, une structure semiconductrice qui comporte simultanément deux hétérojonctions correspondant à deux gaz bidimensionnels d'électrons et de trous. En fait, cette structure est le produit de départ dans lequel seront réalisés, côte à côte et séparés par une gravure (structure mésa) deux transistors, dont l'un utilise le canal n (gaz d'électrons) et l'autre utilise le canal p (gaz de trous). La différenciation est obtenue parce que l'un des transistors est gravé en surface, jusqu'à supprimer l'une des deux hétérojonctions, et parce que l'autre transistor est muni de caissons de prises de contacts qui ne pénètrent pas au-delà de la première hétérojonction, celle-là même qui est supprimée sur le premier transistor. Le second transistor possède donc deux gaz d'électrons et de trous, mais l'un de ces deux gaz ne sert à rien puisqu'il n'est pas connecté sur une source et un drain. Ce procédé a seulement facilité la réalisation d'un transistor à canal n voisin d'un transistor à canal p.

Cependant, pour traiter des signaux alternatifs, ou en logique complémentaire - un transistor à canal n et un transistor à canal p, comme dans les MOS complémentaires - il est intéressant de disposer d'un transistor qui présente l'ambivalence n et p.

C'est ce que propose l'invention, qui réunit dans un seul transistor deux canaux parallèles : un canal n, dans lequel existe un gaz bidimensionnel d'électrons, et un canal p, dans lequel existe un gaz bidimensionnel de trous. Ces deux canaux peuvent coexister et travailler à tour de rôle, ou, selon la valeur des tensions appliquées et la nature des contacts d'accès aux dits canaux, être sélectionnés pour choisir l'un parmi les deux canaux.

Ainsi, le transistor selon l'invention comporte un substrat et, éventuellement, une ou plusieurs couches tampons d'adaptation de paramètres de maille. Sur ce support, une région active est composée de trois couches de matériaux semiconducteurs de la famille III-V, formant entre elles deux hétérojonctions, la couche intermédiaire étant à faible largeur de bande interdite et non intentionnellement dopée. La première et la troisième couches sont en matériaux à grande largeur de bandes interdites et dopées l'une de type n et l'autre de type p, à des niveaux de dopages de l'ordre de $10^{17}$ - $3.10^{18}$ at.cm$^{-3}$, tels que puissent apparaître un gaz bidimensionnel d'électrons, à une première hétérojonction et un gaz bidimensionnel de trous à une deuxième hétérojonction.

De façon plus précise, l'invention consiste en un transistor hyperfréquence à double hétérojonction, comportant, supporté par un substrat en matériaux semiconducteurs semi-isolants, ou non-intentionnellement dopés, une région active sur laquelle sont déposées une électrode de grille Schottky (9), et deux électrodes d'accès dites source (10) et drain (11), ce transistor étant caractérisé en ce que la région active comprend trois couches superposées, la couche intermédiaire étant en matériau semiconducteur de faible largeur de bande interdite, non-intentionnellement dopée, les couches adjacentes étant en matériau semiconducteur de plus grande largeur de bande interdite que celui de la couche intermédiaire, dopées l'une de type n ($n_D \geq 10^{17}$ at.cm$^{-3}$) et l'autre de type p ($n_A \geq 10^{17}$ at.cm$^{-3}$), ces première et troisième couches formant ainsi deux hétérojonctions à leurs interfaces avec la deuxième couche intermédiaire, de sorte qu'il se forme un gaz bidimensionnel d'électrons à l'interface entre la première couche dopée n et la deuxième couche non-intentionnellement dopée, et un gaz bidimensionnel de trous à l'interface entre la deuxième couche non-intentionnellement dopée et la troisième couche dopée p, ce transistor étant ainsi muni de deux canaux conducteurs potentiels, l'un de type n dû au gaz bidimensionnel d'électrons, l'autre de type p dû au gaz bidimensionnel de trous, ces deux canaux conducteurs (7,8) étant simultanément en contact électrique, en parallèle, avec les régions de prises de contact de la source (10) et du drain (11) du transistor.

L'invention sera mieux comprise par la description plus détaillée qui suit de la structure du transistor, et de deux exemples d'application, en conjonction avec les figures jointes en annexes qui représentent :
- fig. 1 : vue en coupe d'un transistor selon l'invention,
- fig. 2 : variante du transistor de la figure précédente,
- fig. 3 et 4 : courbes d'existence des canaux n et p, dans deux cas de tensions de seuils des canaux,
- fig. 5 : courbes d'existence des canaux, pour un transistor fonctionnant en doubleur de fréquence,
- fig.6 :schéma électrique d'un circuit logique complémentaire,
- fig. 7 : limitation de la linéarité en fonction de la tension grille-canal.

Le transistor selon l'invention, essentiellement destiné aux hyperfréquences comprises entre 1 et plusieurs dizaines de gigahertz, est constitué de matériaux rapides de la famille III-V, dont certains ont une faible largeur de bande interdite, par exemple Ga As, par rapport à d'autres qui ont une plus grande largeur de bande interdite, par exemple Al Ga As.

Afin de simplifier le langage, et faciliter la compréhension du texte, on conviendra d'utiliser le mot "Ga As" plutôt que la phrase "matériau semiconducteur à faible largeur de bande interdite", et de même les mots "$Al_x Ga_{1-x}As$" ou "Al Ga As" plutôt que la phrase "matériau semiconducteur à grande largeur de bande interdite". Ceci ne limite nullement la portée de l'invention, et le transistor peut être réalisé en de nombreux alliages III-V binaires, ternaires ou quaternaires, dont les plus courants, outre Ga As et Al Ga As, sont In P, Ga In As, Ga In As P ... etc.

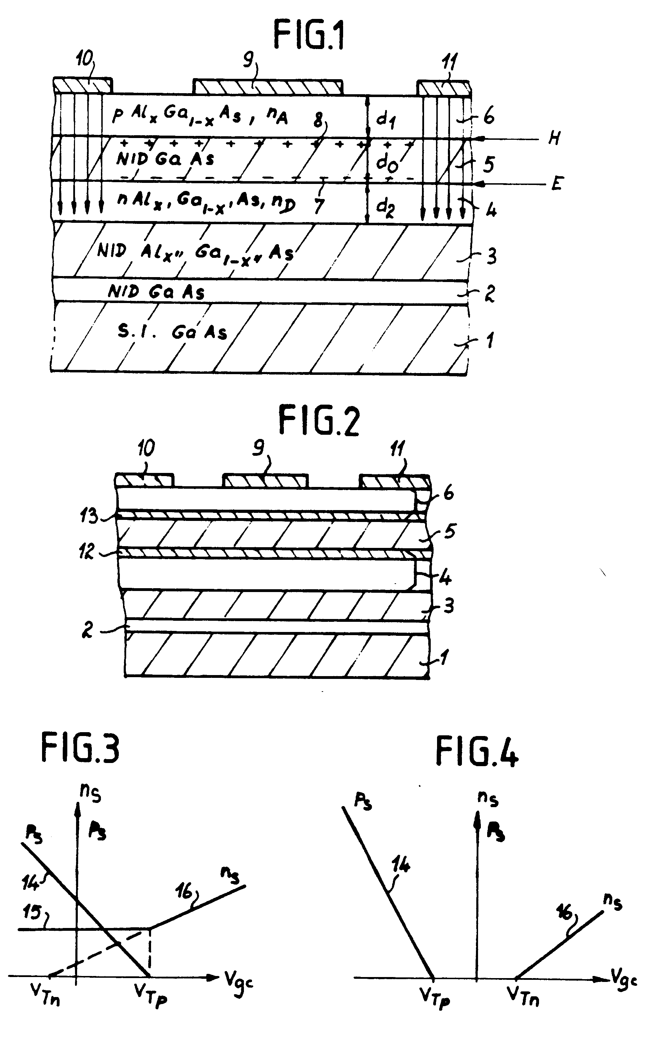

En figure 1 est donnée une vue en coupe d'un transistor selon l'invention. Son substrat comporte un substrat 1 à proprement parler, en Ga As semi-isolant et très généralement une ou deux couches tampons 2 et 3. Dans le cas représenté, une première couche tampon 2 en Ga As non-intentionnellement dopé (NID) sert de couche de lissage, pour le substrat 1, et une deuxième couche tampon 3 en $Al_{x''} Ga_{1-x''}$ As NID évite l'apparition d'un troisième canal conducteur (canal n).

Les couches actives sont constituées par :
- une première couche 4, en $Al_{x'} Ga_{1-x'}$ As, d'épaisseur $d_2$ et dopée par exemple de type n, à un niveau de densité de donneurs $n_D$, supérieur à $10^{17}$ at.cm$^{-3}$,
- une deuxième couche 5 intermédiaire en Ga As, d'épaisseur $d_o$, non-intentionnellement dopée, c'est-à-dire qu'elle peut être aussi faiblement n ou faiblement p, mais de niveau d'impuretés inférieur à $10^{15}$ at.cm$^{-3}$.
- une troisième couche 6, en $Al_x Ga_{1-x}$ As, d'épaisseur $d_1$, et dopée dans ce cas de type p, à un niveau de densité d'accepteurs $n_A$, supérieur à $10^{17}$ at.cm$^{-3}$.

La troisième couche 6, en Al Ga As, et la deuxième couche 5 qui lui est adjacente, en Ga As, forment une hétérojonction, qu'on conviendra d'appeler première hétérojonction, parce qu'en surface, au niveau H, tandis que la deuxième couche 5, en Ga As, et la première couche 4 qui lui est adjacente, en Al Ga As, forment une autre hétérojonction, qu'on conviendra d'appeler deuxième hétérojonction, parce qu'en profondeur, au niveau E.

Les types de dopage n et p des première (4) et troisième (6) couches de Al Ga As peuvent être inversés, mais on verra ultérieurement que cette structure, couche n enterrée et couche p en surface, est plus intéressante.

Si certaines conditions d'épaisseurs, niveaux de dopage, largeurs de bandes interdites ... etc, sont réalisées, il peut se former, sous l'influence d'une tension appliquée sur la grille :
- un gaz bidimensionnel d'électrons 7, à l'intérieur de la deuxième couche 5 de Ga As, à proximité de l'hétérojonction E avec la première couche 4 de Al Ga As,
- un gaz bidimensionnel de trous 8, à l'intérieur de la même deuxième couche 5 de Ga As, à proximité de l'hétérojonction H avec la troisième couche 6 de Al Ga As.

Ce transistor à donc dans ces conditions deux canaux en parallèle, l'un d'électrons en 7 et l'autre de trous en 8.

Si les types de dopage n et p des deux couches 4 et 6 de AlGaAs sont inversés, les gaz bidimensionnels de porteurs de charges sont bien entendu eux aussi inversés.

Le transistor est complété par trois métallisations d'électrodes de grille 9, et de source et drain 10 et 11, déposées en surface de la dernière couche active 6.

La figure 2 donne une vue en coupe d'une variante du transistor de la figure précédente. Selon cette variante, la première couche 4 de $Al_{x'} Ga_{1-x'}$ As comporte une fine sous-couche 12, du même matériau mais non-intentionnellement dopée, en contact avec la deuxième couche 5 de Ga As NID. Et la troisième couche 6 de $Al_x Ga_{1-x}$ As comporte elle aussi une fine sous-couche 13 du même matériau mais non-intentionnellement dopée, en contact avec la deuxième couche 5 de Ga As NID. Ces deux sous-couches 12 et 13, qui n'ont que quelques dizaines d'angströms en épaisseur, sont appelées espaceurs ou "spacers", et ont pour objet d'éloigner les gaz bidimensionnels de porteurs de charges 7 et 8 des couches dopées 4 et 6, et d'accroître la mobilité électronique.

Divers cas de fonctionnement sont possibles pour ce transistor en fonction des paramètres de structure : niveaux de dopages $n_A$ et $n_D$, épaisseurs des couches $d_0$ $d_1$ $d_2$, tension grille-canal $V_{gc}$ appliquée sur la métallisation de grille Schottky 9. Une modélisation simplifiée du dispositif permet le calcul de la tension de seuil de chacun des deux canaux ainsi que, pour chaque cas, la sensibilité de la commande de charge. La simplification appliquée consiste à admettre que :

- les permitivités diélectriques $\epsilon$ sont les mêmes pour toutes les couches : en effet, il y a très peu de variation de $\epsilon$ avec la teneur en aluminium dans Al Ga As,
- l'épaisseur des couches bidimensionnelles d'électrons (2 DEG) et de trous (2 DHG) est négligée. Bien que ces couches aient une épaisseur finie, cette approximation fournit une estimation correcte des tensions seuils,
- il n'y a pas de spacers 12 et 13.

Posons :

$\phi_n$ hauteur de barrière métal-semiconducteur (pour les électrons) à l'interface métal-$Al_x Ga_{1-x}$ As dopé p (couche 6),

$\Delta E_c$ discontinuité énergétique de la bande de conduction aux interfaces 1 (H) et 2 (E) (en supposant pour simplifier que $x = x' = x''$)

$$V_{p1} = \frac{q \, n_A \, d_1^2}{2 \, \epsilon} \; ,$$

dans laquelle q est la charge de l'électron. $V_{p1}$ est homogène à une tension dite tension de perçage.

$E_{g \, GaAs}$ largeur de bande interdite, ou gap, pour Ga As ($\simeq$ 1,4 eV)

$|\epsilon_2|$ valeur absolue du champ électrique à l'interface 2, sensiblement constant, c'est-à-dire peu dépendant de la tension grille-canal $V_{gc}$.

La théorie des transistors TEGFETs à gaz bidimensionnel d'électrons a été établie par D. Delagebeaudeuf et Nuyen T. Linh dans deux articles publiés dans IEEE Transactions on Electron Devices, le premier au volume ED 28, n° 7, pages 790-795, de juillet 1981 et le second au volume ED 29, n° 6, pages 955-960, de juin 1982. En extrapolant cette théorie à la structure du transistor selon l'invention, on trouve pour le canal p (2 DHG) :

- une tension de seuil $V_{Tp}$ définie par :

Equation (1)

$$V_{TP} \simeq \phi_n - \Delta E_c + V_{p1} - E_{g \, Ga \, As} \left(1 + \frac{d_1}{d_o}\right)$$

- une sensibilité de la commande de charge de ce canal p définie par

Equation (2)

$$\frac{d_{ps}}{dV_{gc}} \varpropto - \frac{\epsilon}{q \, d_1}$$

dans laquelle $p_s$ = densité superficielle des trous.

De même, pour le canal n (2 DEG), on trouve :
- une tension de seuil $V_{Tn}$

Equation (3)

$$V_{Tn} \simeq \phi_n - \Delta E_c + V_{p1} - |\epsilon_2| (d_o + d_1)$$

- et une sensibilité de la commande de charge dans le canal n

Equation (4)

$$\frac{dn_s}{dV_{gc}} \simeq \frac{\varepsilon}{q(d_o + d_1)}$$

dans laquelle $n_s$ = densité superficielle d'électrons.

Deux cas sont à considérer, selon les valeurs relatives des tensions de seuil $V_T$ des deux canaux.
Dans le premier cas,
si

$$V_{Tn} < V_{Tp} \quad \text{soit} \quad |\mathcal{E}_2| > \frac{E_g \, Ga \, As}{d_o}$$

il existe un canal n (2 DEG), dit "résiduel" non contrôlé par la grille, pour toute tension grille-canal $V_{gc}$ inférieure à la tension de seuil du canal p :

$$V_{gc} < V_{Tp}$$

C'est ce que représente la figure 3, dans laquelle les densités superficielles $n_s$ et $p_s$ sont portées en ordonnées, et la tension grille canal $V_{gc}$ en abscisses. La tension de seuil $V_{Tn}$ étant inférieure à la tension de seuil $V_{Tp}$, pour toute tension de grille $V_{gc} < V_{Tp}$, le canal p est contrôlé puisque la densité superficielle de trous $p_s$ est contrôlée, selon la droite 14, mais le canal n n'est pas contrôlé parce que la densité superficielle d'électrons $n_s$ reste constante, selon la droite 15. Pour toute tension de grille $V_{gc} > V_{Tp}$, le canal n est contrôlé, en fonction de la droite 16.
Dans le deuxième cas,
si

$$V_{Tn} > V_{Tp} \quad \text{soit} \quad |\mathcal{E}_2| < \frac{E_g \, Ga \, As}{d_o}$$

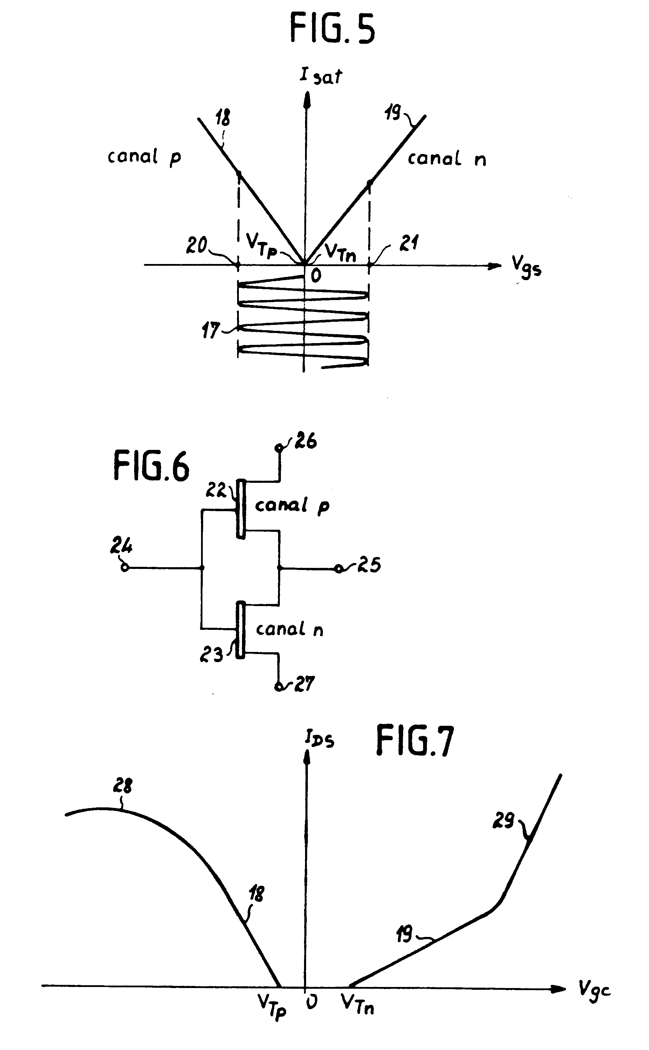

le canal n "résiduel", non contrôlé par la grille, n'existe plus. Mais il existe une zone de tension de grille $V_{gc}$, située entre les deux tensions de seuil $V_{Tn}$ et $V_{Tp}$, dans laquelle la grille n'a plus d'action sur le transistor : il est bloqué.
Ce deuxième cas est représenté en figure 4, qui reprend les mêmes éléments que la figure 3, mais adaptés aux valeurs relatives des tensions de seuil.
Sur ces deux figures, la pente de la droite 14 de densité superficielle de trous est plus grande que la pente de la droite 16 de densité superficielle d'électrons : en accord avec les équations (2) et (4), on constate que la sensibilité de commande du canal n (2 DEG) est plus faible que la sensibilité de commande du canal p (2 DEG). Ceci se comprend aisément : dans la structure choisie, le canal n (2 DEG) est plus éloigné de la grille que le canal p (2 DHG), les électrons sont donc plus loin que les trous par rapport à la grille de contrôle.
Si au contraire on avait choisi d'avoir une couche enterrée 4 dopée p et une couche superficielle 6 dopée n, le même raisonnement s'adapterait en inverse, et on aurait une sensibilité de commande du canal n, en surface, supérieure à la sensibilité de commande du canal p, enterré.

Cependant, il est plus intéressant de conserver la structure telle que choisie en figure 1 : cela permet d'équilibrer et de symétriser les caractéristiques des deux canaux du transistor, parce que l'éloignement du canal n contre-balance la plus grande vitesse des électrons par rapport aux trous, plus rapprochés de la grille. Ainsi, on peut symétriser les caractéristiques du transistor en jouant sur les distances relatives des deux canaux n et p, donc en jouant sur les épaisseurs $d_o$, $d_1$, $d_2$ des couches.

On a supposé jusqu'à présent qu'il n'y a pas de "spacer" 12 et 13. S'il y a un "spacer" 12, à l'interface des couches 4 et 5 n Al Ga As - Ga As, et que son épaisseur est e, une expression approchée du champ électrique $|\epsilon_2|$, résultant de la modélisation des structures TEGFET données dans les deux publications citées, est donnée par l'équation :

Equation (5)

$$\left|\mathcal{E}_2\right| \simeq \frac{q}{\epsilon} \left( \sqrt{\frac{2 \epsilon n_D}{q} \Delta E_c + (n_D e)^2} - n_D e \right)$$

Dans cette expression, l'épaisseur finie de la couche bidimensionnelle 2 DEG a été négligée, comme dans tous les calculs précédents. Une étude plus fine conduit, si l'on veut tenir compte de l'épaisseur de la couche bidimensionnelle, a remplacer e par e + 80Å (environ) dans l'équation (5), 80Å correspondant à la largeur de la couche 2 DEG. Le champ électrique $|\epsilon_2|$ est donc une fonction de $n_D$, $\Delta E_c$, donc de x' dans $Al_{x'}$ $Ga_{1-x'}$ As, et de e, et il peut être ajusté entre deux limites qui sont environ :

Equation (6)

$3.10^6$ V.m$^{-1} \leq |\epsilon_2| \leq 2.10^7$ V.m$^{-1}$

de telle sorte que, compte tenu de la latitude de choix des autres paramètres de structure, il est possible de réaliser des transistors ayant des caractéristiques variées pour des applications variées.

Toutefois, une valeur du champ électrique $|\epsilon_2|$ ayant été définie pour ou imposée par une application donnée, il est préférable de fixer l'épaisseur $d_2$ de la couche 4 en n $Al_{x'}$ $Ga_{1-x'}$ As pour que cette couche soit totalement déplétée, afin d'éliminer toute conduction parasite par des électrons dans cette couche. Cette condition est remplie pour :

Equation (7)

$$d_2 \text{ opt} \simeq \frac{\epsilon |\mathcal{E}_2|}{q\, n_D}$$

A titre d'application du transistor à double hétérojonction selon l'invention, un transistor doubleur de fréquence avec gain constitue un premier exemple. Pour cela, un signal alternatif 17 est appliqué sur la grille du transistor, pour lequel la polarisation continue $V_{gs} = 0$. La figure 5 permet de facilement comprendre le fonctionnement en doubleur : elle représente la variation des transconductances 18 du canal p et 19 du canal n. Si les transconductances à $V_{gs} < O$ et à $V_{gs} > 0$ sont égales en valeur absolue, le signal alternatif 17 appliqué sur la grille est redressé à deux alternances sur le drain : sa phase négative polarise la grille en un point 20, et le canal p (2 DHG) est conducteur, sa phase positive polarise la grille en un point 21 et la canal n (2 DEG) est conducteur. La fréquence de sortie est donc double de la fréquence du signal d'entrée, et le mode fondamental est extrait par filtrage. Mais on profite également du gain du transistor.

Pour qu'un transistor à double hétérojonction puisse convenir à cette application de doubleur de fréquence avec gain, il y a trois conditions.

La première condition est que les contacts des régions de source et drain soient ohmiques vis-à-vis des canaux n et p. Cette condition peut être satisfaite en réalisant les métallisations correspondantes 10 et 11 en contacts ohmiques alliés, qui diffusent dans les couches de matériaux semiconducteurs. C'est ce qui est symbolisé sur la figure 1 par des flèches qui pénètrent dans les couches actives 4, 5 et 6.

La seconde condition est que les transconductances en régimes $V_{gc}<0$ et $V_{gc}>0$ soient égales et opposées en valeurs absolues. Une transcondance est le produit d'une densité de charge par la vitesse des porteurs de charges. Pour une grille submicronique les porteurs se déplacent à leur vitesse limite, $v_{Ln}$ dans le canal n, $v_{Lp}$ dans le canal p, et la transconductance gm pour un canal n de largeur Z est donnée par la relation :

Equation (8)

$$gm = q \, Z v_{Ln} \frac{dn_s}{dV_{gc}}$$

Pour que les transconductances soient égales et opposées en valeur absolue, on doit donc avoir :

$$v_{Ln} \frac{dn_s}{dV_{gc}} = v_{Lp} \left| \frac{dp_s}{dV_{gc}} \right|$$

soit, d'après les équations (2) et (4)

$$\frac{d_o}{d_1} = \frac{v_{Ln}}{v_{Lp}} - 1$$

Pour Ga As - matériau dans lequel se déplacent les deux gaz bidimensionnels 2 DEG et 2 DHG - on a :

$v_{Ln} \simeq 2 \, v_{Lp}$

ce qui conduit à choisir $d_o \simeq d_1$ pour que les transconductances soient égales en valeurs absolues.

L'intérêt de la structure à double hétérojonction est donc de pouvoir symétriser les fonctionnements du transistor en régime canal n ou canal p en jouant uniquement sur des épaisseurs de couches de matériaux semiconducteurs.
La troisième condition est que :

$V_{Tn} \simeq V_{Tp} \simeq 0$

$V_{Tp}$ et $V_{Tn}$ ont été définis par les équations (1) et (3) respectivement, et on pose, pour simplifier l'écriture, que :

$V_o = \phi_n - \Delta E_c + V_{p1}$

Si les deux tensions de seuil sont nulles, on déduit d'après (1) et (3), et en gardant la seconde condition $d_o \simeq d_1$ :

$$\left| \mathcal{E}_2 \right| \simeq \frac{E_{g \, Ga \, As}}{d_o}$$

soit $V_o \simeq 2 \, E_{g \, Ga \, As} = 2,8$ eV
A titre d'application, choisissons $x = x' = x'' = 0,3$, ce qui est une valeur courante. La littérature donne alors $\phi_n \simeq 1$ et $\Delta E_c \simeq 0,3$, d'où $V_{p1} \simeq 2$ volts, ce qui peut être réalisé avec $n_A = 3.10^{17}$ at.cm$^{-3}$, $d_o = d_1 = 1000$ Å.

Dans ce cas, $|\epsilon_2|$ = 1,4.$10^7$ V.m$^{-1}$, ce qui est réalisable d'après la double inégalité (6), et nécessite, avec x = x' = 0,3 et sans spacers, un niveau de dopage $n_D$ = 4.$10^{17}$ at.cm$^{-3}$. L'équation (7) fournit alors $d_2$ opt = 250 Å et l'équation (8) permet le calcul de la transconductance commune aux deux canaux :

gm = 60 mS.-mm$^{-1}$ (avec $v_{Ln} \simeq 10^5$ m.sec$^{-1}$)

Ce calcul n'est donné qu'à titre indicatif, et bien entendu d'autres transconductances plus élevées, et d'autres caractéristiques sont possibles avec d'autres valeurs de conception pour le transistor.

Un autre exemple d'application du transistor à double hétérojonction selon l'invention se trouve dans la logique complémentaire. La cellule de base de la logique complémentaire est rappelée en figure 6. Deux transistors 22 et 23, l'un à canal p, l'autre à canal n, sont attaqués par un signal appliqué simultanément sur leurs deux grilles : le signal entre au point commun 24 et sort au point commun 25. Ces mêmes deux transistors sont alimentés en série entre deux bornes de tension 26 et 27. Les transistors MOS complémentaires silicium sont fréquemment utilisés pour ce type de logique et, selon sa polarité, le signal ouvre le canal n ou le canal p.

Le transistor à double hétérojonction selon l'invention peut également être utilisé en logique complémentaire, puisqu'il possède deux canaux de polarités différentes. Mais, dans un circuit intégré par exemple comprenant une pluralité de tels transistors, il faut avant de déposer les contacts de source et drain 10 et 11, sélectionner le type de conduction désirée, n ou p, par implantations de caissons n$^+$ ou p$^+$ respectivement, pour diminuer les résistances d'accès.

L'intérêt par rapport aux solutions connues réside dans la possibilité de symétriser les deux types de fonctionnement et ainsi de réaliser une complémentarité quasi parfaite, avec un seul type de transistors sur la puce du circuit intégré, certains fonctionnant en canal n et d'autres fonctionnant en canal p.

Pour cette application, chacun des deux transistors - celui qui utilise le canal n et celui qui utilise le canal p - doit être normalement bloquant (normally off), donc fonctionnant en régime d'enrichissement, ce qui se traduit pour le transistor proposé par les inégalités :

$V_{Tn} > 0$ et $V_{Tp} < 0$

La complémentarité impose de plus :

$V_{Tn} = | V_{Tp} | = V_T$

et

$d_o \simeq d_1$

ce qui implique :

$V_o \simeq 2 E_g - V_T$

$$|\epsilon_2| \simeq \frac{E_g - V_T}{d_o} = \frac{E_g - V_T}{d_1}$$

d'où

$$V_{p1} = \frac{q \, n_A \, d_1^2}{2 \, \epsilon} = 2 E_g \, Ga \, As - \phi_n + \Delta E_c - V_T$$

$$d_1 = \frac{E_g \, Ga \, As - V_T}{|\epsilon_2|}$$

La transconductance commune aux deux transistors est alors donnée par l'expression :

$$gm = \frac{\epsilon \, Z \, v_{Ln}}{2 \, d_1}$$

A titre d'application, choisissons $x = x' = x'' = 0,3$ (ce qui entraîne $\Delta E_c \simeq 0,3$ et $\phi_n \simeq 1$) et $V_T = 0,5$ volt ainsi que gm = 150 mS.mm$^{-1}$.

La littérature donne $v_{Ln} = 10^5$ m.sec$^{-1}$. On en tire par le calcul :

$d_o = d_1 \simeq 400$ Å

$V_{p1} = 1,6$ V ce qui est réalisable pour $n_A \simeq 1,5.10^{18}$ at.cm$^{-3}$

$|\epsilon_2| = 2,25.10^7$ V.m$^{-1}$.

Le choix d'une transconductance élevée conduit à un champ électrique $|\epsilon_2|$ lui-même élevé, mais qui reste réalisable sans spacer puisqu'il nécessite un dopage de la couche 4 de n Al Ga As de:

$n_D \simeq 1,5.10^{18}$ at.cm$^{-3}$

qui est une valeur couramment utilisée pour les couches n Al Ga As des TEGFETs.

Bien entendu, d'autres solutions sont possibles pour des choix de valeurs différentes.

En toute rigueur, le transistor à double hétérojonction selon l'invention ne fonctionne en concordance avec les équations citées précédemment que dans une plage limitée de tension grille-canal $V_{gc}$. En effet, et la figure 7 l'illustre, la modélisation prévoit que :
- pour des tensions $V_{gc}$ suffisamment négatives, il y a perte de contrôle du canal p, ce qui correspond à la partie 28 de la couche de transconductance de la figure 7,
- pour des tensions $V_{gc}$ suffisamment positives, il y a ouverture d'un second canal n, en 29, de transconductance plus élevée que celle du premier canal, en 19.

Toutefois, ces tensions extrêmes, $V_{gc}$ sont situées hors la gamme des tensions habituellement pratiquées avec les transistors hyperfréquences.

Bien entendu, de même qu'il a été précisé plus haut qu'on choisirait d'exposer l'invention en s'appuyant sur le cas d'un transistor en Ga As - Al Ga As, sans limitation à la portée de l'invention, de même l'homme du métier pourra facilement rétablir les équations en considérant le champ électrique $|\epsilon_1|$ à l'interface 1 plutôt que le champ électrique $|\epsilon_2|$ à l'interface 2. Le choix qui a été fait repose sur l'avantage qu'a la structure de la figure 1 de symétriser les caractéristiques des deux canaux n et p. Mais une structure inverse -canal n près de la grille, canal p éloigné de la grille - peut au contraire dans certains cas apporter un intérêt : par exemple pour avoir un canal n dont la transconductance est nettement plus élevée que la transconductance du canal p.

De façon plus générale, l'invention concerne un transistor à double hétérojonction entre matériaux semiconducteurs à faible largeur de bande interdite et à grande largeur de bande interdite, dopés de façon à créer deux canaux conducteurs de gaz bidimensionnel, l'un de type n (2 DEG), l'autre de type p (2 DHG), qui existent simultanément ou alternativement selon la tension appliquée sur la grille du transistor hyperfréquences, précisé par les revendications suivantes.

## Revendications

1. Transistor hyperfréquence à double hétérojonction, comportant, supporté par un substrat (1, 2, 3) en matériaux semiconducteurs semi-isolants, ou non-intentionnellement dopés, une région active sur laquelle sont déposées une électrode de grille Schottky (9), et deux électrodes d'accès dites source (10) et drain (11), ce transistor étant caractérisé en ce que la région active comprend trois couches (4, 5, 6) superposées, la couche intermédiaire (5) étant en matériau semiconducteur de faible largeur de bande interdite, non-intentionnellement dopée (n < $10^{15}$ at.cm$^{-3}$), les couches adjacentes (4, 6) étant en matériau semiconducteur de plus grande largeur de bande interdite que celui de la couche intermédiaire (5), dopées l'une (4) de type n ($n_D \geq 10^{17}$ at.cm$^{-3}$) et l'autre (6) de type p ($n_A \geq 10^{17}$ at.cm$^{-3}$), ces première (4) et troisième (6) couches formant ainsi deux hétérojonctions à leurs interfaces avec la deuxième couche (5) intermédiaire, de sorte qu'il se forme un gaz bidimensionnel d'électrons (7) à l'interface entre la première couche (4) dopée n et la deuxième couche (5) non-intentionnellement dopée, et un gaz bidimensionnel de trous (8) à l'interface entre la deuxième couche (5) non-intentionnellement dopée et la troisième couche (6) dopée p, ce transistor étant ainsi muni de deux canaux conducteurs potentiels, l'un de type n (7) dû au gaz bidimensionnel d'électrons, l'autre de type p (8)

dû au gaz bidimensionnel de trous, ces deux canaux conducteurs (7,8) étant simultanément en contact électrique, en parallèle, avec les régions de prises de contact de la source (10) et du drain (11) du transistor.

2. Transistor selon la revendication 1, caractérisé en ce qu'il est réalisé en matériaux de la famille III-V, les couches à faible largeur de bande interdite (5) et à grande largeur de bande interdite (4, 6) étant choisies parmi les alliages binaires, ternaires ou quaternaires de Ga, As, Al, In, P, Sb, tels que Ga As, $Al_x Ga_{1-x}$ As, In P, $Ga_x In_{1-x}$ As.

3. Transistor selon la revendication 1, caractérisé en ce que la première couche (4) de matériau à grande largeur de bande interdite dopée n est située entre le substrat (1, 2, 3) et la deuxième couche intermédiaire (5) à faible largeur de bande interdite, et en ce que la troisième couche (6) de matériau à grande largeur de bande interdite dopée p est située entre la deuxième couche intermédiaire (5) et la métallisation de grille (9), de sorte que le gaz bidimensionnel d'électrons (2 DEG) (7) est plus éloigné de la grille (9) que le gaz bidimensionnel de trous (2 DHG) (8).

4. Transistor selon la revendication 3, caractérisé en ce que les tensions de seuil $V_{Tn}$ pour le canal n (7) et $V_{Tp}$ pour le canal p (8) sont données par :

$$V_{Tn} \simeq \phi_n - \Delta E_c + V_{p1} - |\epsilon_2| (d_0 + d_1)$$

et

$$V_{Tp} \simeq \phi_n - \Delta E_c + V_{p1} - E_g \left(1 + \frac{d_1}{d_0}\right)$$

$\phi_n$ et $\Delta E_c$ étant exprimees en volts,
et en ce que les sensibilités de commande de charge électrique dans le canal n (7) et dans le canal p (8) sont données respectivement par:

$$\frac{dn_s}{dV_{gc}} \simeq \frac{\epsilon}{q (d_0 + d_1)}$$

et

$$\frac{dp_s}{dV_{gc}} \simeq \frac{\epsilon}{q\, d_1}$$

expressions dans lesquelles :
- $\phi_n$ est la hauteur de barrière métal/semiconducteur, pour les électrons, à l'interface grille (9)-/troisième couche (6) dopée p,
- $\Delta E_c$ est la discontinuité énergétique de la bande de conduction aux deux hétérojonctions,
- $V_{p1}$ est la tension de perçage,
- $|\epsilon_2|$ est la valeur absolue du champ électrique à l'interface entre la première couche (4) et la deuxième couche (5),
- $d_0$ et $d_1$ sont les épaisseurs, respectivement, des deuxième (5) et troisième (6) couches,
- $E_g$ est la largeur de bande interdite de la deuxième couche (5),

- $n_s$ est la densité superficielle d'électrons, dans le canal n (7),
- $p_s$ est la densité superficielle de trous, dans le canal p (8),
- $V_{gc}$ est la tension grille-canal, pour un canal considéré,
- $\epsilon$ est la permitivité diélectrique du matériau semiconducteur,
- q est la charge de l'électron.

5. Transistor selon la revendication 4, caractérisé en ce que, si $V_{Tn} < V_{Tp}$, le transistor est conducteur par le canal p (8) pour une tension grille-canal $V_{gc} < V_{Tp}$ et est conducteur par le canal n (7) pour une tension $V_{gc} > V_{Tp}$, le canal n (7) n'étant pas contrôlé pour $V_g < V_{Tp}$.

6. Transistor selon la revendication 4, caractérisé en ce que, si $V_{Tn} > V_{Tp}$, le transistor est conducteur par le canal p (8) pour une tension grille-canal $V_{gc} < V_{Tp}$ et par le canal n (7) pour une tension $V_{gc} > V_{Tn}$, et est bloqué pour $V_{Tp} < V_{gc} < V_{Tn}$.

7. Transistor selon la revendication 4, caractérisé en ce que, le gaz bidimensionnel d'électrons (7) étant plus éloigné de la grille (9) que le gaz bidimensionnel de trous (8), la sensibilité de commande du canal n (7), proportionnelle à $1/(d_1 + d_o)$, est plus faible que la sensibilité de commande du canal p (8), proportionnelle à $1/d_1$.

8. Transistor selon la revendication 7, caractérisé en ce que, la transconductance d'un canal étant proportionnelle à la vitesse limite $v_L$ des porteurs de charges électriques dans ce canal, et la vitesse limite $v_{Ln}$ des électrons dans le canal n (7) étant plus grande que la vitesse limite $v_{Lp}$ des trous dans le canal p (8), les transconductances des deux canaux n (7) et p (8) sont rendues égales en donnant aux couches dopées p (6) et non-intentionnellement dopées (5) des épaisseurs respectives $d_1$ et $d_o$ liées par la relation :

$$\frac{d_o}{d_1} = \frac{v_{Ln}}{v_{Lp}} - 1$$

les caractéristiques des deux canaux (7, 8) du transistor étant ainsi rendues symétriques.

9. Transistor selon la revendication 8, caractérisé en ce que, $d_2$ étant l'épaisseur de la couche (4) dopée n, cette couche (4) est totalement déplétée pour une épaisseur optimale

$$d_{2\,opt.} \simeq \frac{\epsilon\,|\mathcal{E}_2|}{q\,n_D}$$

10. Transistor selon la revendication 4, caractérisé en ce qu'il constitue un doubleur de fréquence d'un signal alternatif appliqué sur sa grille (9) si les tensions de seuils $V_{Tn}$ et $V_{Tp}$ de ses deux canaux n (7) et p (8) sont égales à zéro, c'est-à-dire si :

$$|\mathcal{E}_2| \simeq \frac{E_g}{d_o}$$

11. Transistor selon la revendication 4, caractérisé en ce qu'il constitue un transistor à deux canaux complémentaires n (7) et p (8), normalement bloqués si :

$$V_{Tn} = |V_{Tp}| = V_T$$

ce qui est obtenu pour :

$$d_1 = \frac{E_g - V_T}{\sqrt{\left|\varepsilon^2\right|}}$$

## Claims

1. Double-heterojunction ultrahigh-frequency transistor, including, supported by a substrate (1, 2, 3) made from semi-insulating or unintentionally-doped semiconductor materials, an active region onto which a Schottky-gate (9) electrode and two access electrodes, called source the (10) and drain the (11), are deposited, this transistor being characterised in that the active region comprises three superposed layers (4, 5, 6), the intermediate layer (5) being made from a narrow band-gap semiconductor material, this layer being unintentionally doped ($n < 10^{15}$ at.cm$^{-3}$), the adjacent layers (4, 6) being made from a semiconductor material of wider band-gap than that of the material of the intermediate layer (5), one (4) of these layers being n-type doped ($n_D \geq 10^{17}$ at.cm$^{-3}$) and the other (6) of p-type doped ($n_A \geq 10^{17}$ at.cm$^{-3}$), these first (4) and third (6) layers thus forming two heterojunctions at their interfaces with the intermediate second layer (5), so that a two-dimensional electron gas (7) is formed at the interface between the n-doped first layer (4) and the unintentionally-doped second layer (5), and a two-dimensional hole gas (8) is formed at the interface between the unintentionally-doped second layer (5) and the p-doped third layer (6), this transistor thus being provided with two potential conducting channels, the n-type one (7) due to the two-dimensional electron gas and the other, p-type one (8) due to the two-dimensional hole gas, these two conducting channels (7, 8) being simultaneously in electrical contact, in parallel, with the regions for contacting the source (10) and drain (11) of the transistor.

2. Transistor according to Claim 1, characterised in that it is produced from materials of Group III-V, the narrow band-gap layer (5) and the wide band-gap layers (4, 6) being selected from binary, ternary or quaternary alloys of Ga, As, Al, In, P, Sb, such as GaAs, $Al_xGa_{1-x}As$, InP, $Ga_xIn_{1-x}As$.

3. Transistor according to Claim 1, characterised in that the first layer (4) of n-doped wide band-gap material is located between the substrate (1, 2, 3) and the narrow band-gap intermediate second layer (5), and in that the third layer (6) of p-doped wide band-gap material is located between the intermediate second layer (5) and the gate (9) metallisation, so that the two-dimensional electron gas (2 DEG) (7) is further from the gate (9) than the two-dimensional hole gas (2 DHG) (8).

4. Transistor according to Claim 3, characterised in that the threshold voltages $V_{Tn}$ for the n channel (7) and $V_{Tp}$ for the p channel (8) are given by:

$V_{Tn} \approx \phi_n - \Delta E_c + V_{p1} - |\varepsilon_2| (d_0 + d_1)$

and

$V_{Tp} \approx \phi_n - \Delta E_c + V_{p1} - E_g (1 + d_1/d_0)$

$\phi_n$ and $\Delta E_c$ being expressed in volts, and in that the electrical charge control sensitivities in the n channel (7) and in the p channel (8) are given respectively by:

$$\frac{dn_s}{dV_{gc}} \approx \frac{\varepsilon}{q(d_0 + d_1)}$$

and

13

$$\frac{dp_s}{dV_{gc}} \approx \frac{\epsilon}{qd_1}$$

in which expressions:

- $\phi_n$ is the metal/semiconductor barrier height, for the electrons, at the gate (9)/p-doped third layer (6) interface,
- $\Delta E_c$ is the energy discontinuity of the conduction band at the two heterojunctions,
- $V_{p1}$ is the breakdown voltage,
- $|\epsilon_2|$ is the absolute value of the electric field at the interface between the first layer (4) and the second layer (5),
- $d_0$ and $d_1$ are the thicknesses, respectively, of the second (5) and the third (6) layers,
- $E_g$ is the band-gap width of the second layer (5),
- $n_s$ is the surface density of electrons, in the n channel (7),
- $p_s$ is the surface density of holes, in the p channel (8),
- $V_{gc}$ is the gate-channel voltage, for a channel in question,
- $\epsilon$ is the dielectric permitivity of the semiconductor material and
- q is the electronic charge.

5. Transistor according to Claim 4, characterised in that, if $V_{Tn} < V_{Tp}$, the transistor conducts via the p channel (8) for a gate-channel voltage $V_{gc} < V_{Tp}$ and conducts via the n channel (7) for a voltage $V_{gc} > V_{Tp}$, the n channel (7) not being controlled for $V_g < V_{Tp}$.

6. Transistor according to Claim 4, characterised in that, if $V_{Tn} > V_{Tp}$, the transistor conducts via the p channel (8) for a gate-channel voltage $V_{gc} < V_{Tp}$ and via the n channel (7) for a voltage $V_{gc} > V_{Tn}$, and is turned off for $V_{Tp} < V_{gc} < V_{Tn}$.

7. Transistor according to Claim 4, characterised in that, because the two-dimensional electron gas (7) is further from the gate (9) than the two-dimensional hole gas (8), the control sensitivity of the n channel (7), proportional to $1/(d_1 + d_0)$, is lower than the control sensitivity of the p channel (8), proportional to $1/d_1$.

8. Transistor according to Claim 7, characterized in that, because the transconductance of a channel is proportional to the limiting velocity $v_L$ of the electrical charge carriers in this channel and the limiting velocity $v_{Ln}$ of the electrons in the n channel (7) is greater than the limiting velocity $v_{Lp}$ of the holes in the p channel (8), the transconductances of the n channel (7) and p channel (8) are rendered equal by giving the p-doped (6) and unintentionally-doped (5) layers respectively thicknesses $d_1$ and $d_0$ which are related by the expression:

$$\frac{d_0}{d_1} = \frac{v_{Ln}}{v_{Lp}} - 1$$

the characteristics of the two channels (7, 8) of the transistor being thus rendered symmetrical.

9. Transistor according to Claim 8, characterised in that, since $d_2$ is the thickness of the n-doped layer (4), this layer (4) is completely depleted for an optimum thickness

$$d_2 \; opt. \approx \frac{\epsilon |\epsilon_2|}{qn_D}$$

14

10. Transistor according to Claim 4, characterized in that it constitutes a frequency doubler for an alternating signal applied to its gate (9) if the threshold voltages $V_{Tn}$ and $V_{Tp}$ of both its n (7) and p (8) channels are equal to zero, that is to say if:

$$\left| \vec{\mathcal{E}}_2 \right| \approx \frac{E_g}{d_0}$$

11. Transistor according to Claim 4, characterized in that it constitutes a transistor having two complementary channels, n (7) and p (8), normally turned off if:

$$V_{Tn} = |V_{Tp}| = V_T$$

which is obtained for:

$$d_1 = \frac{E_g - V_T}{\left| \vec{\mathcal{E}}_2 \right|}$$

**Patentansprüche**

1. Mikrowellentransistor mit doppeltem Heteroübergang, der auf einem Substrat (1, 2, 3) aus halbisolierendem oder nicht bewußt dotiertem Halbleitermaterial eine aktive Zone aufweist, auf der eine Schottky-Gate-Elektrode (9) und zwei Zugangselektroden, Source (10) und Drain (11) genannt, angeordnet sind, dadurch gekennzeichnet, daß die aktive Zone drei übereinanderliegende Schichten (4, 5, 6) enthält, wobei die Zwischenschicht (5) aus einem Halbleitermaterial mit einer geringen Breite des verbotenen Bands, das nicht bewußt dotiert ist (n < $10^{15}$ at.cm$^{-3}$) und die daran anschließenden Schichten (4, 6) aus einem Halbleitermaterial mit einer größeren Breite des verbotenen Bands als die Zwischenschicht (5) bestehen, wobei eine dieser Schichten (4) vom Typ n ($n_D \geq 10^{17}$ at.cm$^{-3}$) und die andere (6) vom Typ p ist ($n_A \geq 10^{17}$ at.cm$^{-3}$), wobei die erste und die dritte Schicht (4, 6) zwei Heteroübergänge an ihrem Übergang zur Zwischenschicht (5) bilden, derart, daß sich ein zweidimensionales Elektronengas (7) am Übergang zwischen der ersten Schicht mit n-Dotierung (4) und der zweiten, nicht bewußt dotierten Schicht (5) und ein zweidimensionales Löchergas (8) am Übergang zwischen der zweiten, nicht bewußt dotierten Schicht (5) und der dritten Schicht (6) mit p-Dotierung bildet, sodaß dieser Transistor zwei mögliche Leitkanäle besitzt, einen vom Typ n (7) aufgrund des zweidimensionalen Elektronengases und einen anderen vom Typ p (8) aufgrund des zweidimensionalen Löchergases, wobei diese beiden leitenden Kanäle (7, 8) gemeinsam und parallel in elektrischem Kontakt mit den Kontaktzonen der Source (10) und des Drains (11) des Transistors stehen.

2. Transistor nach Anspruch 1, dadurch gekennzeichnet, daß er aus einem Material der Familie III-V besteht, wobei die Schichten mit einer geringen Breite des verbotenen Bands (5) und einer großen Breite des verbotenen Bands (4, 6) aus den binären, ternären oder quaternären Legierungen von Ga, As, Al, In, P, Sb ausgewählt werden, wie z.B. GaAs, $Al_xGa_{1-x}As$, InP, $Ga_xIn_{1-x}As$.

3. Transistor nach Anspruch 1, dadurch gekennzeichnet, daß die erste Schicht (4) des Materials mit einer großen Breite des verbotenen Bands und n-Dotierung zwischen dem Substrat (1, 2, 3) und der zweiten Schicht (Zwischenschicht 5) mit geringer Breite des verbotenen Bands liegt und daß die dritte Schicht (6) aus Material mit einer großen Breite des verbotenen Bands und p-Dotierung zwischen der Zwischenschicht (5) und dem Gate-Metallbelag (9) liegt derart, daß das zweidimensionale Elektronengas (2 DEG) (7) vom Gate (9) weiter entfernt ist, als das zweidimensionale Löchergas (2 DHG) (8).

4. Transistor nach Anspruch 3, dadurch gekennzeichnet, daß die Schwellenspannungen $V_{Tn}$ für den Kanal vom Typ n (7) und $V_{Tp}$ für den Kanal vom Typ p (8) durch folgende Beziehungen gegeben sind

15

$$V_{Tn} \simeq \phi_n - \Delta E_c + V_{p1} - |E_2| (d_o + d_1)$$
$$V_{Tp} \simeq \phi_n - \Delta E_c + V_{p1} - E_g (1 + d_1/d_o)$$

wobei $\phi_n$ und $\Delta E_c$ in Volt ausgedrückt werden, und daß die Steuerempfindlichkeit der elektrischen Ladung im Kanal vom Typ n (7) und im Kanal vom Typ p (8) durch folgende Beziehungen gegeben sind

$$\frac{dn_s}{dV_{gc}} \simeq \frac{\epsilon}{q (d_o + d_1)}$$

$$\frac{dp_s}{dV_{gc}} \simeq - \frac{\epsilon}{q \, d_1}$$

wobei gilt:
- $\phi_n$ ist die Höhe der Barriere Metall/Halbleiter für die Elektronen am Übergang vom Gate (9) zur dritten Schicht (6) mit p-Dotierung,
- $\Delta E_c$ ist die Energiediskontinuität des Leitbandes an den beiden Heteroübergängen,
- $V_{p1}$ ist die Durchschlagsspannung,
- $|E_2|$ ist der Absolutwert des elektrischen Felds, am Übergang zwischen der ersten Schicht (4) und der zweiten Schicht (5),
- $d_o$ und $d_1$ sind die Dicken der zweiten und dritten Schichten (5, 6),
- $E_g$ ist die Breite des verbotenen Bands der zweiten Schicht (5),
- $n_s$ ist die oberflächliche Elektronendichte im Kanal vom Typ n (7),
- $p_s$ ist die oberflächliche Löcherdichte im Kanal vom Typ p (8),
- $V_{gc}$ ist die Spannung zwischen Gate und Kanal für einen betrachteten Kanal,
- $\epsilon$ ist die Dielektrizitätskonstante des Halbleitermaterials,
- q ist die Elektronenladung.

5. Transistor nach Anspruch 4, dadurch gekennzeichnet, daß für den Fall $V_{Tn} < V_{Tp}$ der Transistor über den Kanal (8) vom Typ p für eine Spannung $V_{gc}$ zwischen Gate und Kanal größer als $V_{Tp}$ leitend ist, während er über den Kanal (7) vom Typ n für eine Spannung $V_{gc}$ leitend ist, die kleiner als $V_{Tp}$ ist, wobei der Kanal (7) vom Typ n für $V_g < V_{Tp}$ nicht gesteuert wird.

6. Transistor nach Anspruch 4, dadurch gekennzeichnet, daß im Fall $V_{Tn} > V_{Tp}$ der Transistor im Kanal (8) vom Typ p für eine Spannung $V_{gc}$ zwischen Gate und Kanal kleiner als $V_{Tp}$ leitend ist und über den Kanal (7) vom Typ n für eine Spannung $V_{gc} > V_{Tn}$ leitend ist, während er blockiert ist für $V_{Tp} < V_{gc} < V_{Tn}$.

7. Transistor nach Anspruch 4, dadurch gekennzeichnet, für den Fall, daß das zweidimensionale Elektronengas (7) weiter entfernt vom Gate (9) als das zweidimensionale Löchergas (8) ist, die Steuerempfindlichkeit des Kanals vom Typ n (7), die proportional zu $1/(d_1 + d_o)$ ist, geringer als die Steuerempfindlichkeit des Kanals p (8) ist, die proportional zu $1/d_1$ ist.

8. Transistor nach Anspruch 7 dadurch gekennzeichnet, daß, wenn die Transkonduktanz eines Kanals proportional zur Grenzgeschwindigkeit $v_L$ der elektrischen Ladungsträger in diesem Kanal und die Grenzgeschwindigkeit $v_{Ln}$ der Elektronen im Kanal (7) vom Typ n größer als die Grenzgeschwindigkeit $v_{Lp}$ der Löcher in dem Kanal (8) vom Typ p ist, die Transkonduktanzen der beiden Kanäle (7, 8) vom Typ n bzw. p gleich gemacht werden, indem die Dicken $d_1$ und $d_0$ der Schicht (6) mit p-Dotierung und der nicht bewußt dotierten Schicht (5) so gewählt werden, daß folgende Gleichung gilt

$$\frac{d_o}{d_1} = \frac{v_{Ln}}{v_{Lp}} - 1$$

wodurch die Kennwerte der beiden Kanäle (7, 8) des Transistors symmetrisch gemacht werden.

9.  Transistor nach Anspruch 8, dadurch gekennzeichnet, daß, wenn $d_2$ die Dicke der Schicht (4) mit n-Dotierung ist, diese Schicht (4) völlig an Ladungsträgern abgereichert ist für eine optimale Dicke

$$d_{2\ opt.} \simeq \frac{\epsilon |E_2|}{q\, n_D}$$

10. Transistor nach Anspruch 4 dadurch gekennzeichnet, daß er einen Frequenzverdoppler für ein Wechselstromsignal bildet, das an sein Gate (9) angelegt wird, wenn die Schwellenspannungen $V_{Tn}$ und $V_{Tp}$ seiner beiden Kanäle (7, 8) vom Typ n bzw. p Null sind, d.h. wenn

$|E_2| \sim E_g/d_o$

11. Transistor nach Anspruch 4, dadurch gekennzeichnet, daß er einen Transistor mit zwei komplementären Kanälen (7, 8) vom Typ n bzw. p bildet, die normalerweise gesperrt sind, wenn

$V_{Tn} = |V_{Tp}| = V_T$,

wobei dies erfüllt wird für

$$d_1 = \frac{E_g - V_T}{|E_2|}$$

# FIG.1

# FIG.2

# FIG.3

# FIG.4

# FIG.5

# FIG.6

# FIG.7